# EUROPEAN PATENT APPLICATION

(11) **EP 4 819 821 A1**
(43) Date of publication of application: **07.10.2026**
(21) Application number: 26163001.6
(22) Date of filing: 06.03.2026
(51) Int. Cl.: H10N 60/01, H03F 19/00, H10N 60/20, H10N 60/81, G06N 10/40

(54) **KINETIC INDUCTANCE TRAVELLING-WAVE PARAMETRIC AMPLIFIER (KTWPA) WITH VACUUM GAP**

(30) Priority: 31.03.2025 US 202519096041
(71) Applicant: Microsoft Technology Licensing, LLC, Redmond, WA 98052-6399 (US)
(72) Inventor: Nystrom, Michael James, Redmond, 98052-6399 (US); Chapman, Benjamin James, Redmond, 98052-6399 (US); Chien, Tzu-Chiao, Redmond, 98052-6399 (US)
(74) Representative: Page White Farrer

(57) **Abstract**

An improved kinetic inductance travelling-wave parametric amplifier (KTWPA) device is provided that includes a first substrate (206), a superconducting trace (204) having a first height (H1), the superconducting trace fabricated on the first substrate, a plurality of spacers (208) having a second height (H2), each of the plurality of spacers fabricated on the first substrate, the second height greater than the first height of the superconducting trace, a ground plane (210) bonded to a second substrate (212), the ground plane further bonded to the plurality of spacers, and a vacuum gap (202) formed between the first substrate and the ground plane. A superconducting transmission line assembly (200) is formed by the superconducting trace and the ground plane separated by the vacuum gap having the second height. The KTWPA device is applied in a quantum microwave measurement circuit for amplifying weak quantum microwave signals at a very low noise floor.

## Description

### BACKGROUND

Quantum computers typically make use of quantum-mechanical phenomena, such as superposition and entanglement, to perform operations on data more efficiently than a classical digital computer which stores and manipulates information in the form of bits (e.g., a "1" or "0"). By contrast, quantum computing systems can manipulate information using qubits. Superposition is a fundamental concept in quantum mechanics, describing the condition in which a quantum system can exist in multiple states or configurations simultaneously. A qubit can refer to a quantum device that enables the superposition of multiple states (e.g., data in both the "0" and "1" state) and/or to the superposition of data, itself, in the multiple states. In accordance with conventional terminology, the superposition of a "0" and "1" state in a quantum system may be represented, e.g., as α|0 ^{>} +β|1^{>}. The "0" and "1" states of a digital computer are analogous to the |0^{>} and |1^{>} basis states, respectively of a qubit. The value |α|² represents the probability that a qubit is in |0^{>} state, whereas the value |β|² represents the probability that a qubit is in the |1^{>} basis state. Because a qubit can be in a superposition of 0 and 1, the quantum computer can perform multiple computations in parallel by processing all possible states of the qubits at once.

Quantum computing research has made significant progress in both quantum algorithms and quantum hardware toward improving the computational power and reliability of quantum computing. Quantum computers based on topological qubits are a promising path to scaled, low-error quantum computing. Unlike current qubit implementations, which are often based on elementary particles such as ions, electrons or photons, topological qubits are based on a topological state, or phase, of matter. Topological qubits are theorized to be more stable than any other qubit engineered to date because quantum information is stored in the topological properties of a physical system rather than in the properties of individual particles or atoms. An example implementation for topological qubits includes storing quantum information in the two ends of a superconducting nanowire. Topological qubits are less sensitive to noise at either end individually.

One-dimensional topological superconductors (1DTSs) are a promising platform for building topological qubits. The basic structure of a topological qubit places a suitable semiconductor nanowire in close proximity to a superconductor. Due to the proximity, the semiconductor nanowire also becomes superconducting and under the right conditions, including an appropriate magnetic field along the wire and voltages applied to the device, the semiconductor nanowire enters the topological phase. Quantum information is stored in the fermion parity of Majorana zero modes (MZMs) localized at the ends of superconducting wires, and projective measurements of the fermion parity are used to process quantum information and perform qubit state readout. The fermion parity shared by a pair of MZMs in the quantum device can be determined through reflectometry measurement.

The interferometric measurement of a quantum device such as the 1DTS is performed in part by using a microwave readout chain that is designed to minimize the system noise temperature. A near-quantum limited amplifier such as a kinetic inductance travelling-wave parametric amplifier (KTWPA) device is often chosen as the first amplifier in the readout chain that is coupled to the quantum device to obtain reflectometry measurements at the desired very low noise level, along with various low-pass and infrared filters and shielding to suppress stray radiation from impinging on the quantum device.

Another requirement for the KTWPA device includes the ability to amplify weak microwave signals from the reflectance measurement of the quantum device at a very low noise floor. This capability is highly dependent on the qualities of the superconducting transmission line employed in the KTWPA device. Traditional superconducting transmission lines that employ a buried superconducting trace in a physical dielectric are limited by higher losses at microwave frequencies. It would be desirable to provide a KTWPA device employing a superconducting transmission line with a vacuum gap to provide improved amplification of weak microwave signals at a very low noise floor.

### SUMMARY

An example kinetic inductance travelling-wave parametric amplifier (KTWPA) device includes a first substrate, a superconducting trace having a first height fabricated on the first substrate, a plurality of spacers having a second height, each of the plurality of spacers fabricated on the first substrate, the second height being greater than the first height of the superconducting trace, a ground plane coupled to a second substrate and the plurality of spacers, and a vacuum gap formed between the first substrate and the ground plane. A superconducting transmission line assembly is formed from the superconducting trace and the ground plane separated by the vacuum gap having the second height.

An example method for fabricating a kinetic inductance travelling-wave parametric amplifier (KTWPA) device includes providing a first substrate, fabricating a superconducting trace on the first substrate, the superconducting trace having a first height, fabricating a plurality of spacers on the first substrate, the plurality of spacers having a second height greater than the first height of the superconducting trace, providing a second substrate, coupling a ground plane to the second substrate, coupling the ground plane to the plurality of spacers, and forming a superconducting transmission line assembly from the superconducting trace and the ground plane separated by a vacuum gap having the second height.

An example quantum microwave measurement circuit includes a kinetic inductance travelling-wave parametric amplifier (KTWPA) device having an input port and an output port, the KTWPA device further including a first substrate, a superconducting trace having a first height fabricated on the first substrate, a plurality of spacers having a second height, each of the plurality of spacers fabricated on the first substrate, the second height being greater than the first height of the superconducting trace, a ground plane coupled to a second substrate the plurality of spacers, a vacuum gap formed between the first substrate and the ground plane, wherein a superconducting transmission line assembly is formed from the superconducting trace and the ground plane separated by the vacuum gap having the second height, a metallic enclosure having a base with an inside top surface, sides, and an enclosure lid, the metallic enclosure forming a vacuum cavity for containing the first substrate and the second substrate to form the vacuum gap, and a first circulator coupled to a quantum circuit to receive a quantum measurement signal.

The quantum microwave measurement circuit further includes a first microwave triplexer coupled to the first circulator to receive the quantum measurement signal and further coupled to the input port of the KTWPA device, the first microwave triplexer receiving a bias-in voltage and a microwave pump-in signal, a second microwave triplexer coupled to the output port of the KTWPA device to receive an amplified quantum measurement signal, the second microwave triplexer receiving a bias-out voltage and a microwave pump-out signal, a second circulator coupled to the second microwave triplexer to receive the amplified quantum measurement signal, and an analog-to-digital converter (ADC) coupled to the second circulator to receive the amplified quantum measurement signal and provide a quantum measurement value. The KTWPA device, the first circulator, the second circulator, the first microwave triplexer and the second microwave triplexer are cooled to less than 100 mK.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter. Furthermore, the claimed subject of this disclosure.

### BRIEF DESCRIPTION OF THE DRAWINGS

The drawing figures depict one or more implementations in accord with the present teachings, by way of example only, not by way of limitation. In the figures, like reference numerals refer to the same or similar elements. Furthermore, it should be understood that the drawings are not necessarily to scale.
FIG. 1 is a block diagram of a quantum microwave readout circuit implementing the KTWPA device as disclosed for low noise amplification.
FIG. 2 illustrates a cross-sectional view of a superconducting transmission line assembly with a vacuum gap.
FIG. 3 is a cross-sectional view of the superconducting transmission line assembly mounted in a metallic enclosure.
FIG. 4 is a view of the superconducting trace fabricated on a substrate.
FIG. 5 is an orthogonal view of the superconducting transmission line assembly mounted in the metallic enclosure.
FIGs.6A-6B depict a view of two steps of the manufacturing process for forming the superconducting transmission line assembly of FIG. 2.
FIGs.7A-7B depict a view of two steps of the manufacturing process for forming the superconducting transmission line assembly of FIG. 2.
FIGs.8A-8B depict a view of two steps of the manufacturing process for forming the superconducting transmission line assembly of FIG. 2.
FIG. 9 shows a flow process of a method for forming the KTWPA device of FIG. 4.

### DETAILED DESCRIPTION

Kinetic inductance travelling-wave parametric amplifier (KTWPA) devices have become increasingly desirable to apply in microwave readout chains to measure large numbers of frequency-multiplexed microwave superconducting resonators at the quantum limit. KTWPA devices, compared with other quantum limited amplifiers such as devices that incorporate Josephson junctions, typically exhibit a combination of high dynamic range, wide frequency bandwidth, and low noise. Further proposed applications of microwave measurement chains include orders of magnitude more quantum devices that will need to be simultaneously read out, making the application of KTWPA devices even more prevalent.

Quantum superconducting transmission lines have been implemented as coplanar waveguides (CPWs), with the ground being substantially parallel to the plane of the substrate. Superconducting transmission lines are deployed in quantum circuits that use microwaves to control the qubits, for example to initialize, manipulate (e.g., couple), and read out the qubits. The quantum signals at microwave frequency ranges are generally delivered and supported using superconducting transmission lines, which are a fundamental type of component in various quantum circuits. To achieve the desired characteristics related to low noise amplification of quantum measurement signals, KTWPA devices rely on a low-loss superconducting transmission line built around a superconducting trace. However, lossy dielectrics along the superconducting transmission line often dominate dissipation in the system, thus limiting the performance of the superconducting transmission line and the KTWPA device.

Existing superconducting transmission lines have been constructed using a "buried" superconducting trace that may either be partially buried, such as with only a portion extending into the substrate or completely buried, such as where an entire structure is provided in an opening in the substrate. The superconducting transmission line as implemented in a KTWPA device is typically constructed with a relatively long physical length, requiring that the superconducting trace be arranged in more compact patterns, for example, serpentine patterns, on the substrate. The choice of materials to construct the superconducting trace in the KTWPA device is also important and Niobium Titanium Nitride (NbTiN) is often used given its unique properties for low dissipation and higher nonlinearity below a critical temperature in the range of 100 mK for superconductivity.

It is further desirable that the KTWPA device be constructed in a metallic enclosure to provide a local vacuum environment for the superconducting transmission line that reduces the dissipation and frequency noise resulting from lossy interfaces and surface adsorbates by enclosing the exposed surfaces of the superconducting transmission line in the local vacuum environment. The vacuum environment may also reduce the number of molecules that are weakly bound to the exposed surfaces of the superconducting transmission line, providing for more stable operation. A getter may be added to the interior surface of the metallic enclosure to further remove gas molecules from the local vacuum environment.

Implementing the KTWPA device raises various engineering and packaging technical problems. The compact arrangement of the superconducting trace, which operates as a superconducting transmission line, requires a consistent ground plane along its entire length in order to maintain the desired gain, bandwidth, and noise characteristics. It would be desirable to provide a KTWPA device with a superconducting transmission line structure employing a vacuum gap in place of the buried superconducting trace and related method of fabrication that overcome the problems related to the losses related to the buried superconducting trace while maintaining a consistent the ground plane to a compact and reliable solution for an improved KTWPA device.

The present invention describes an improved superconducting transmission structure using a vacuum gap as implemented in the KTWPA device. The superconducting trace is fabricated on a substrate and is separated from a ground plane by the vacuum gap, which has an advantage of providing improved amplification of weak microwave signals at a very low noise floor. Methods of fabricating the KTWPA device having the improved superconducting transmission structure. The height of the vacuum gap is determined by spacers coupled to the substrate, which has a further advantage providing for simplified fabrication of the KTWPA device.

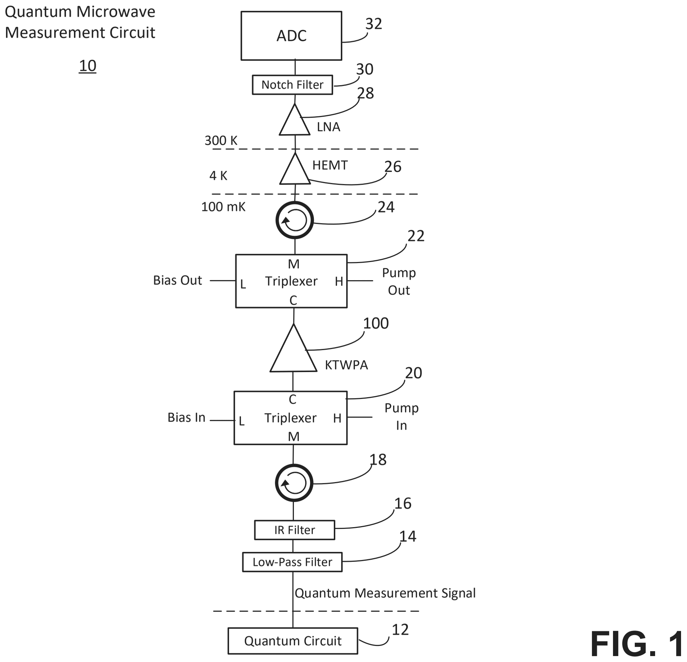

FIG. 1 is a block diagram of a quantum microwave readout circuit 10 implementing a KTWPA device 100 as disclosed in further detail below to provide low noise amplification of weak microwave signals. A first microwave circulator 18 is coupled via a low-pass filter 14 and an infrared filter 16 to a quantum circuit 12 to receive a quantum measurement signal. The measurement is typically performed as part of a larger measurement system that provides microwave reflectometry measurements of a 1DTS topological qubit device for determining the fermion parity shared by a pair of MZMs. The low-pass filter 14 and infrared filter 16 each have characteristics selected to suppress stray radiation from impinging on the quantum circuit 12.

A first microwave triplexer 20 is coupled to the first circulator 18 to receive the quantum measurement signal, a bias-in voltage, and a microwave pump-in signal to produce a combined input signal that is provided to an input port of the KTWPA device 100. The KTWPA device operates to amplify the quantum measurement signal at a desired very low noise level while reliably handling the pump in signal that is typically provided at a sufficient amplitude required by the KTWPA device 100 to function as intended. A second microwave triplexer 22 is coupled to an output port of the KTWPA device 100 to receive a combined output signal. The second microwave triplexer 22 operates to separate the combined output signal into a microwave pump-out signal, a bias-out voltage, and an amplified quantum measurement signal. A second microwave circulator 24 is coupled to the second microwave triplexer 22 to receive the amplified quantum measurement signal. An analog-to-digital converter (ADC) 32 is coupled to second microwave triplexer 22 via a high electron mobility amplifier (HEMT) 26, a low noise amplifier (LNA) 26, and a notch filter 30 to receive a filtered quantum measurement signal to produce a quantum measurement value. The ADC 32 has selected sampling speed and resolution to match the requirements of the quantum microwave measurement circuit 10. A first portion of the quantum microwave measurement circuit 10 from low pass filter 14, the IR filter 16, the circulator 18, the first microwave triplexer 20, the KTWPA device 100, the second microwave triplexer 22, and the second microwave circulator 24 are all maintained less than 100 mK to maintain superconductivity. The HEMT 26 may be at a higher temperature, typically around 4K, and the LNA 28, the notch filter 30 and the ADC 32 may be at approximately 300K or typical room temperature. The KTWPA device 100 is applied in the quantum microwave measurement circuit 10 to achieve very low noise amplification of the quantum measurement signal, as described in more detail below.

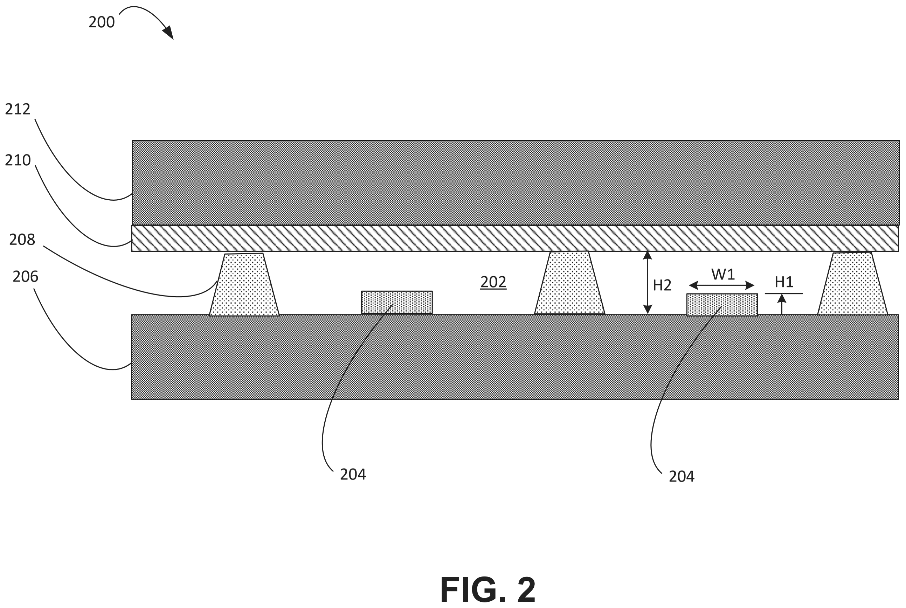

FIG. 2 illustrates a cross-sectional view of a superconducting transmission line assembly 200 with a vacuum gap 202. A superconducting trace 204 is fabricated on a substrate 206. The superconducting trace 204 is a superconducting thin film that may be fabricated from various superconducting materials that include aluminum (Al), niobium (Nb), niobium nitride (NbN), titanium nitride (TiN), niobium titanium nitride (NbTiN), indium (In), and molybdenum rhenium (MoRe), all of which are particular types of superconducting thin films at qubit operating temperatures. Niobium titanium nitride (NbTiN) is preferably used in an implementation based on the particular properties of NbTiN as a superconducting transmission line structure with unique properties for low dissipation and higher nonlinearity below a critical temperature less than 100 mK for superconductivity. The substrate 206 is constructed, for example, from silicon having a surface oxide that operates as a dielectric. Aluminum nitride (AlN) may be an alternative for constructing the substrate 206, with characteristics that include high thermal conductivity, high electrical insulation, and low dielectric constant.

Spacers 208 are bonded to the substrate 206 proximate to the superconducting trace 204 at regular intervals along the entire length as fabricated on the substrate 206. The spacers 208 may be constructed, for example, from patterned and electroplated copper pillars, conductive adhesives applied in conjunction with spacers, solder bumps, and gold stud bumps. A further alternative includes microspheres which are glass particles with or without a metal coating that may be dispersed between the substrate 206 and a substrate 212. The spacers 208 must be mechanically rigid and provide a desired height above the substrate 206 at the intended operating temperature of the KTWPA device 100 of less than 100mk.

A ground plane 210 is bonded to a substrate 212. The ground plane may be constructed, for example, from copper, copper alloy, or similar metals that are highly electrically conductive at microwave frequencies and superconducting temperatures. Optionally, the superconducting properties of the metal chosen for the ground plane 210 can be considered. The substrate 212, similar to the substrate 206, is constructed, for example, from silicon having a surface oxide that operates as a dielectric, or alternatively from aluminum nitride (AlN) that provides high thermal conductivity, high electrical insulation, and low dielectric constant.

The substrate 212 and the ground plane 210 are bonded to the spacers 208 to form the superconducting transmission line assembly 200 with the vacuum gap 202. The characteristics of the superconducting transmission line formed by the superconducting trace 204 and the ground plane 210 separated by the vacuum gap 202 are determined in part by a first height H1 and width W1 of the superconducting trace 204 and a second height H2 of the vacuum gap 202 that is set by the spacers 208. The use of the vacuum gap 202 rather than the dielectric of prior implementations provides the advantages of the substantially lower loss and improved noise floor performance of the KTWPA device operating at microwave frequencies for the purpose of amplifying weak microwave signals as part of the quantum measurement signal from the quantum circuit 12. The mechanical integrity of the superconducting transmission line assembly 200 relies in part on the substrate 206 and the substrate 212.

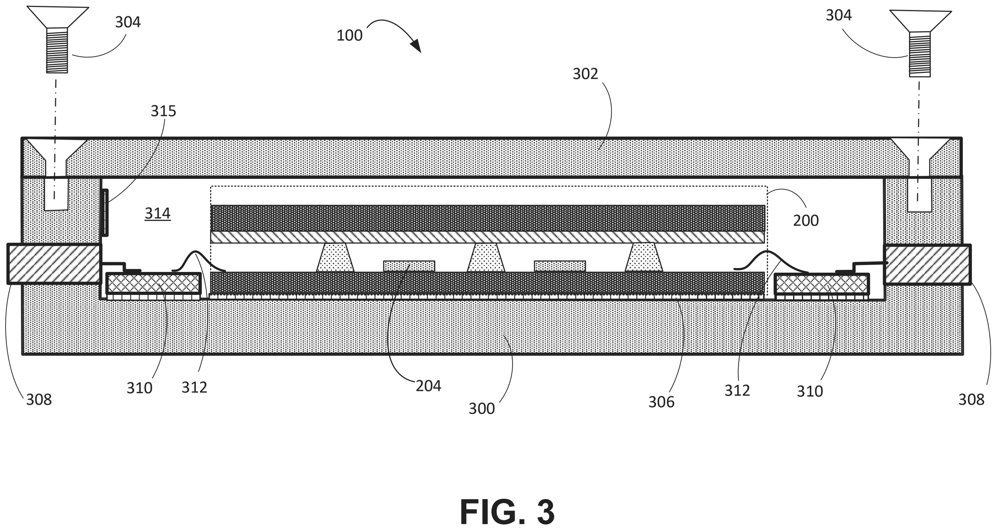

FIG. 3 is a cross-sectional view of the superconducting transmission line assembly 200 mounted in a metallic enclosure 300 with an enclosure lid 302 attached to the metallic enclosure 300 using, for example, machine screws 304, to form the KTWPA device 100. The superconducting transmission line assembly 200 is bonded to the metallic enclosure 300 using an adhesive 306. Radio frequency (RF) connectors 308 are installed in the metallic enclosure 300 to form an input port and an output port for the KTWPA device 100. The RF connectors 308 are coupled via printed circuit boards 310 having conductive pads and further via wire bonds 312 to the superconducting trace 204. The RF connectors 308 may include SMA or similar wide bandwidth coaxial connectors. Alternatively, the substrate 206 could be extended to include conductive pads for connecting with the wire bonds 312 directly without using the printed circuit boards 310.

The metallic enclosure 300 and the enclosure lid 302 form a cavity that is hermetically sealed in which a local vacuum environment 314 is created. Air and other gas molecules are evacuated from the cavity to a preferred pressure range to provide for proper operation of the superconducting transmission line assembly 200 in which the vacuum gap 202 is coupled to the local vacuum environment 314 and is at the same pressure. The vacuum gap 202 has a pressure of less than or equal to 1 microTorr. A getter 315 may be added to the interior surface of the cavity for further removing gas molecules from the local vacuum environment 314 by combining with gas molecules through chemical bonds or by absorption.

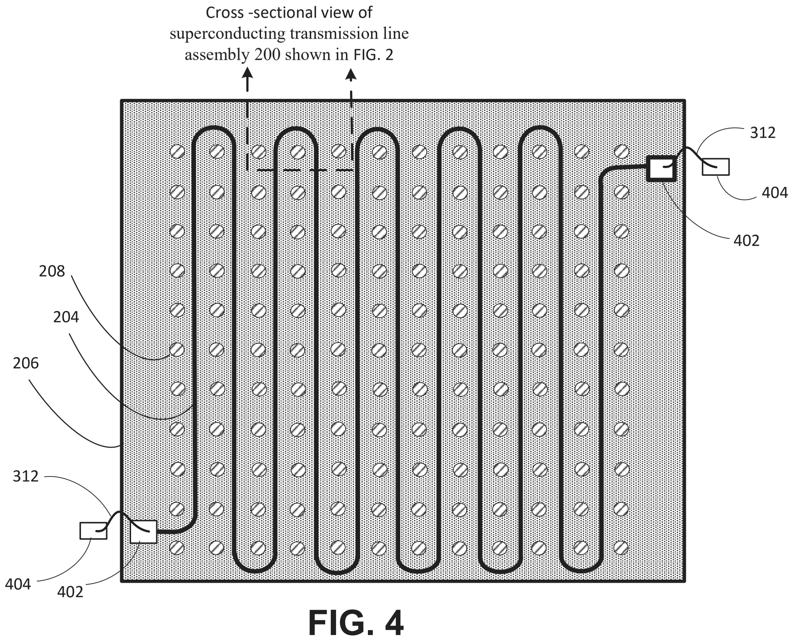

FIG. 4 is a view of a portion of the superconducting transmission line assembly 200 that is fabricated on the substrate 206. For clarity, the dashed lines indicate the cross-sectional view of the superconducting transmission line assembly 200 shown in FIG. 2. The substrate 212 and the ground plane 210 are not shown in FIG. 4. The superconducting trace 204 is shown as a serpentine pattern in order to obtain a relatively long electrical length while maintaining a compact overall size of the superconducting transmission line assembly 200. Other routing patterns may be readily substituted that provide a more compact physical profile of the superconducting transmission line assembly 200. The spacers 208 are arranged along the length of the superconducting trace 204, with layout of the spacers 208 determined by the physical requirements to maintain a desired tolerance of the first height H1. Conductive pads 402 are fabricated to each end of the superconducting trace 204. The conductive pads 402 are coupled to conductive pads 404 via the wire bonds 312. The conductive pads 404 may be fabricated on the printed circuit boards 310 (not shown) or similar insulating material and are further coupled to the RF connectors 308 to provide the input port and the output port of the KTWPA device 100.

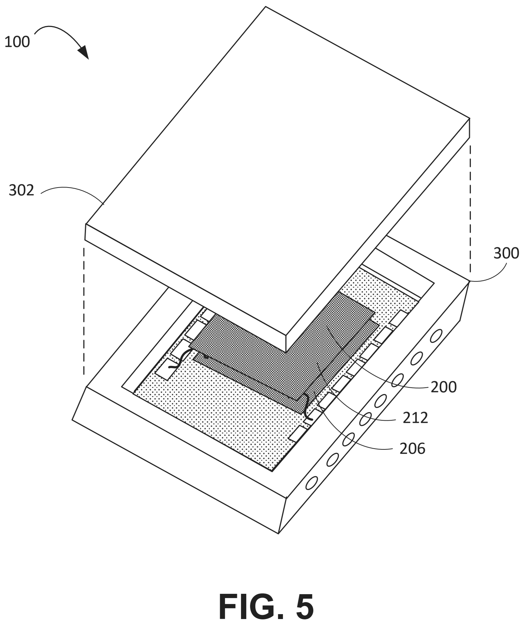

FIG. 5 is an orthogonal view of the superconducting transmission line assembly 200 mounted in the metallic enclosure 300 with the enclosure lid 302. The metallic enclosure 300 and the enclosure lid 302 form a cavity that is hermetically sealed in which a local vacuum environment 314 is created. Air and other gas molecules are evacuated from the cavity to a preferred pressure range to provide for proper operation of the superconducting transmission line assembly 200. The metallic enclosure 300 with the enclosure lid 302 are constructed from metal or metal alloys that are thermally conductive and dimensionally stable in the superconducting temperature range. Further, the metallic enclosure 300 with the enclosure lid 302 may also provide magnetic shielding for the superconducting transmission line assembly 200, which may be desirable given the limited space available in a superconducting refrigerator and close proximity to other superconducting components that emit stray electromagnetic fields.

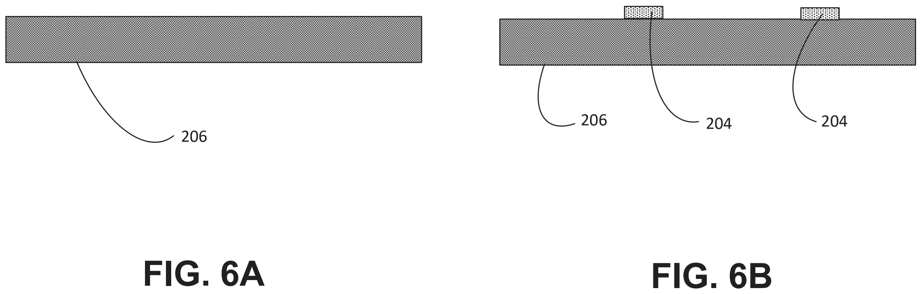

FIGs.6A-6B depict a view of two steps of the manufacturing process for forming the transmission line assembly of FIG. 2. FIG. 6A shows the step of providing the substrate 206. The substrate 206 is constructed, for example, from silicon having a surface oxide that operates as a dielectric. Aluminum nitride (AlN) may be an alternative for constructing the substrate 206, with characteristics that include high thermal conductivity, high electrical insulation, and low dielectric constant.

FIG. 6B shows the step of fabricating the superconducting trace 204 on to the top surface of the substrate 206. As mentioned previously, the superconducting trace 204 may be fabricated as a serpentine pattern in order to obtain a relatively long electrical length while maintaining a compact overall size of the superconducting transmission line assembly 200. Other patterns may be readily substituted that provide a more compact physical profile of the superconducting transmission line assembly 200.

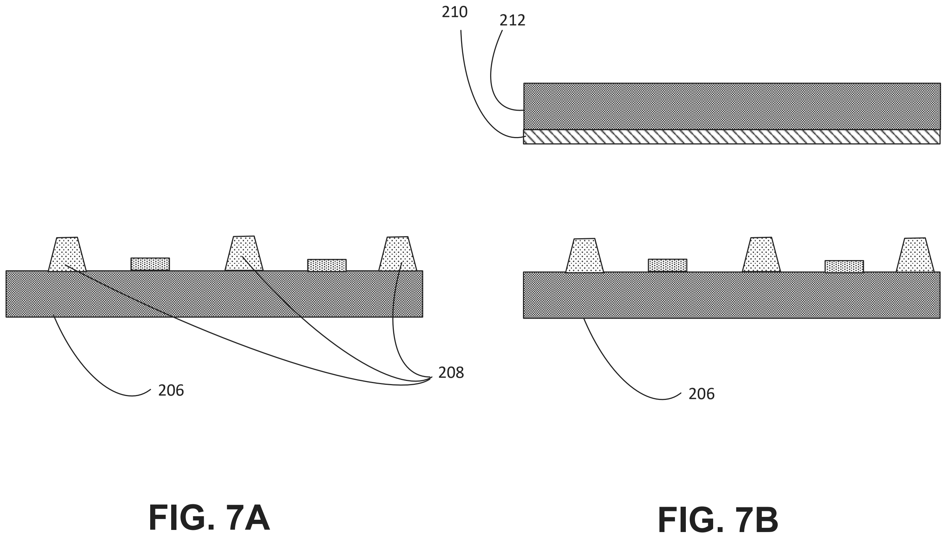

FIGs.7A-7B depict a view of two steps of the manufacturing process for forming the transmission line assembly of FIG. 2. FIG. 7A shows the step of bonding spacers 208 to the top surface of the substrate 206. The spacers 208 are bonded to the substrate 206 proximate to the superconducting trace 204 at regular intervals along its entire length as fabricated on the substrate 206. The spacers 208 may be constructed, for example, from patterned and electroplated copper pillars, conductive adhesives applied in conjunction with spacers, solder bumps, or gold stud bumps. A further alternative includes microspheres which are glass particles with or without a metal coating that may be dispersed between the substrate 206 and the substrate 212. The spacers 208 must be mechanically rigid and provide a desired height above the substrate 206 at the intended operating temperature of the KTWPA device 100 of less than 100 mk. FIG. 7B shows the step of bonding the ground plane 210 to the substrate 212. The ground plane may be constructed, for example, from copper, copper alloy, or similar metals that are highly conductive at microwave frequencies and superconducting temperatures. The substrate 212, similar to the substrate 206, is constructed, for example, from silicon having a surface oxide that operates as a dielectric, or alternatively from aluminum nitride (AlN) that provides high thermal conductivity, high electrical insulation, and low dielectric constant.

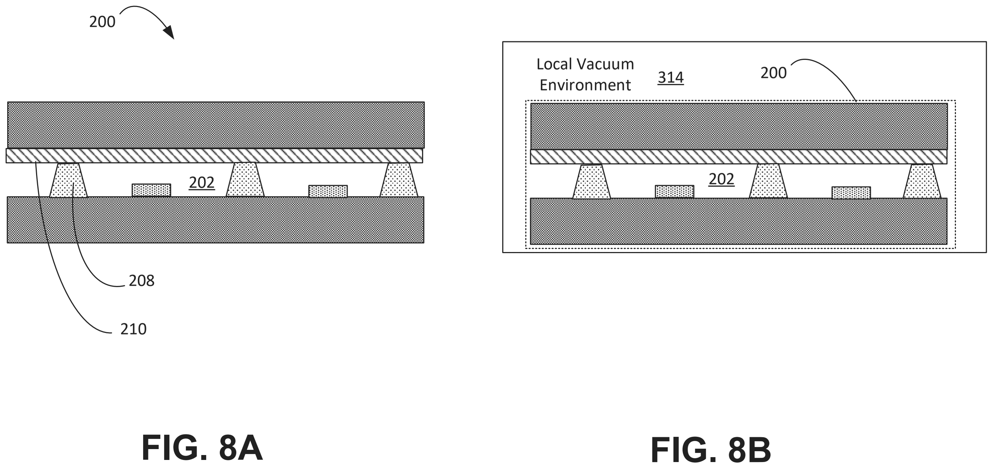

FIGs.8A-8B depict a view of two steps of the manufacturing process for forming the superconducting transmission line assembly 200 of FIG. 2. FIG. 8A shows the step of bonding the ground plane 210 to each of the spacers 208 to form the superconducting transmission line assembly 200 with the vacuum gap 202. FIG. 8B shows the step of providing a local vacuum environment 314. Air and other gas molecules are evacuated from the cavity formed by the metallic enclosure 300 and the enclosure lid 302 to a preferred pressure range to provide for the proper operation of the superconducting transmission line assembly 200 in which the vacuum gap 202 is coupled to the local vacuum environment 314 and is at the same pressure.

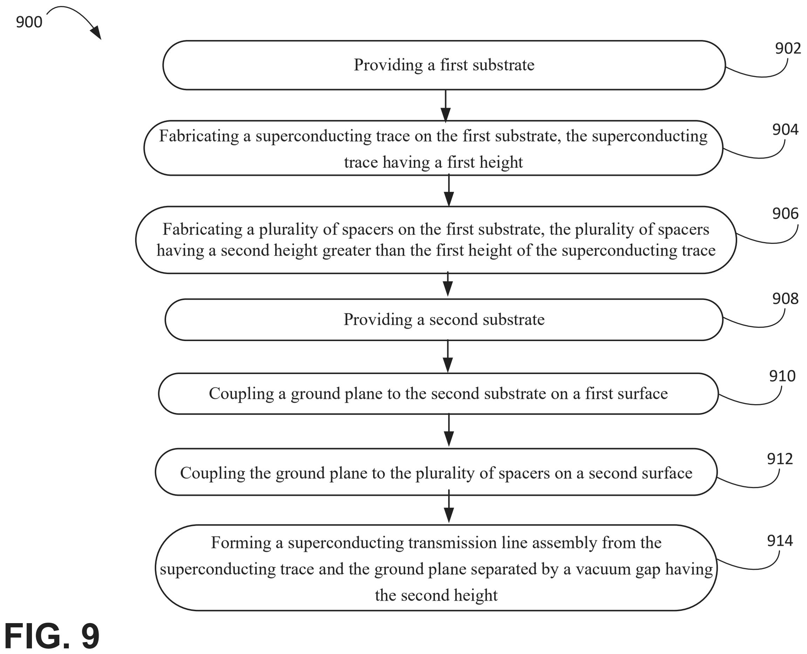

FIG. 9 shows a flow process 900 of a method for forming the KTWPA device 100 of FIG. 4. The flow process 900 includes the step 902 for providing a first substrate 206. The the substrate 206, is constructed, for example, from silicon having a surface oxide that operates as a dielectric, or alternatively from aluminum nitride (AlN) that provides high thermal conductivity, high electrical insulation, and low dielectric constant.

The flow process 900 further includes the step 904 for fabricating a superconducting trace 204 on the first substrate 206, the superconducting trace having a first height H1. Niobium titanium nitride (NbTiN) is preferably used in an implementation based on the particular properties of NbTiN as a superconducting transmission line structure with unique properties for low dissipation and higher nonlinearity below a critical temperature less than 100 mK for superconductivity.

The flow process 900 further includes the step 906 for fabricating a plurality of spacers 208 on the first substrate 206. The plurality of spacers having a second height H2 greater than the first height H1 of the superconducting trace 204. The spacers 208 must be mechanically rigid and provide a desired height above the substrate 206 at the intended operating temperature of the KTWPA device 100 of less than 100mk.

The flow process 900 further includes the step 908 for providing a second substrate 212. The substrate 212, similar to the substrate 206, is constructed, for example, from silicon having a surface oxide that operates as a dielectric. Alternatively, the substrate 212 may be constructed from aluminum nitride (AlN) that provides high thermal conductivity, high electrical insulation, and low dielectric constant.

The flow process 900 further includes the step 910 for coupling the ground plane 210 to the second substrate 212 on a first surface. The ground plane 210 may be constructed, for example, from copper, copper alloy, or similar metals that are highly conductive at microwave frequencies and superconducting temperatures.

The flow process 900 further includes the step 912 for coupling the ground plane 210 to the spacers 208 on a second surface. The superconducting transmission line assembly 200 is formed from the combination of the substrate 206, the substrate 212, the ground plane 210, the spacers 208, and the superconducting trace 204. The mechanical integrity of the superconducting transmission line assembly 200 relies in part on the substrate 206 and the substrate 212.

The flow process 900 further includes the step 914 for forming a a superconducting transmission line assembly 200 from the superconducting trace 204 and the ground plane 210 separated by a vacuum gap 202 having the second height H2 Air and other gas molecules are evacuated from the cavity formed by the metallic enclosure 300 and the enclosure lid 302 to a preferred pressure range to provide for the proper operation of the superconducting transmission line assembly 200 in which the vacuum gap 202 is coupled to the local vacuum environment 314 and is at the same pressure.

While various embodiments have been described, the description is intended to be exemplary, rather than limiting, and it is understood that many more embodiments and implementations are possible that are within the scope of the embodiments. Although many possible combinations of features are shown in the accompanying figures and discussed in this detailed description, many other combinations of the disclosed features are possible. Any feature of any embodiment may be used in combination with or substituted for any other feature or element in any other embodiment unless specifically restricted. Therefore, it will be understood that any of the features shown and/or discussed in the present disclosure may be implemented together in any suitable combination. Accordingly, the embodiments are not to be restricted except in light of the attached claims and their equivalents. Also, various modifications and changes may be made within the scope of the attached claims.

While the foregoing has described what are considered to be the best mode and/or other examples, it is understood that various modifications may be made therein and that the subject matter disclosed herein may be implemented in various forms and examples, and that the teachings may be applied in numerous applications, only some of which have been described herein. It is intended by the following claims to claim any and all applications, modifications and variations that fall within the true scope of the present teachings.

Unless otherwise stated, all measurements, values, ratings, positions, magnitudes, sizes, and other specifications that are set forth in this specification, including in the claims that follow, are approximate, not exact. They are intended to have a reasonable range that is consistent with the functions to which they relate and with what is customary in the art to which they pertain.

The scope of protection is limited solely by the claims that now follow. That scope is intended and should be interpreted to be as broad as is consistent with the ordinary meaning of the language that is used in the claims when interpreted in light of this specification and the prosecution history that follows and to encompass all structural and functional equivalents. Notwithstanding, none of the claims are intended to embrace subject matter that fails to satisfy the requirement of Sections 101, 102, or 103 of the Patent Act, nor should they be interpreted in such a way. Any unintended embracement of such subject matter is hereby disclaimed.

Except as stated immediately above, nothing that has been stated or illustrated is intended or should be interpreted to cause a dedication of any component, step, feature, object, benefit, advantage, or equivalent to the public, regardless of whether it is or is not recited in the claims.

It will be understood that the terms and expressions used herein have the ordinary meaning as is accorded to such terms and expressions with respect to their corresponding respective areas of inquiry and study except where specific meanings have otherwise been set forth herein. Relational terms such as first and second and the like may be used solely to distinguish one entity or action from another without necessarily requiring or implying any actual such relationship or order between such entities or actions. The terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus. An element proceeded by "a" or "an" does not, without further constraints, preclude the existence of additional identical elements in the process, method, article, or apparatus that comprises the element. Furthermore, subsequent limitations referring back to "said element" or "the element" performing certain functions signifies that "said element" or "the element" alone or in combination with additional identical elements in the process, method, article or apparatus are capable of performing all of the recited functions.

The disclosure provides many different embodiments, or examples, for implementing different features of the provided subject matter. Specific examples of components and arrangements are described to simplify the present disclosure. These are merely examples and are not intended to be limiting. For example, the formation of a first feature over or on a second feature in the description that follows may include embodiments in which the first and second features are formed in direct contact, and may also include embodiments in which additional features may be formed between the first and second features, such that the first and second features may not be in direct contact. Further, spatially relative terms, such as "beneath," "below," "lower," "above," "upper," "back," "front," "top," "bottom," and the like, are used herein for ease of description to describe one element or feature's relationship to another element(s) or feature(s) as illustrated in the figures. The spatially relative terms are intended to encompass different orientations of the device in use or operation in addition to the orientation depicted in the figures.

The Abstract of the Disclosure is provided to allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in various examples for the purpose of streamlining the disclosure. This method of disclosure is not to be interpreted as reflecting an intention that the claims require more features than are expressly recited in each claim. Rather, as the following claims reflect, inventive subject matter lies in less than all features of a single disclosed example. Thus, the following claims are hereby incorporated into the Detailed Description, with each claim standing on its own as a separately claimed subject matter.

## Claims

1. A kinetic inductance travelling-wave parametric amplifier, KTWPA, device, the KTWPA device comprising:
a first substrate;
a superconducting trace having a first height fabricated on the first substrate;
a plurality of spacers having a second height, each of the plurality of spacers fabricated on the first substrate, the second height being greater than the first height of the superconducting trace;
a ground plane coupled to a second substrate and the plurality of spacers, and
a vacuum gap formed between the first substrate and the ground plane, wherein a superconducting transmission line assembly is formed from the superconducting trace and the ground plane separated by the vacuum gap having the second height.

2. The KTWPA device of claim 1, further comprising a metallic enclosure having a base with an inside top surface, sides, and an enclosure lid, the metallic enclosure forming a vacuum cavity for containing the first substrate and the second substrate to form the vacuum gap.

3. The KTWPA device of claim 2, wherein the first substrate is bonded to the inside top surface of the base, and the first substrate includes a plurality of conductive pads;
optionally further comprising:
a) a plurality of radio frequency, RF, connectors installed in the sides of the metallic enclosure and coupled to the plurality of conductive pads; and/or
b) a plurality of wire bonds attached between the plurality of conductive pads and the superconducting trace.

4. The KTWPA device of any preceding claim, wherein the superconducting trace is arranged in a serpentine pattern that is fabricated adjacent to the plurality of spacers on the first substrate.

5. The KTWPA device of any preceding claim, wherein the superconducting trace is a superconducting thin film;
optionally wherein the superconducting thin film comprises Niobium Titanium Nitride NbTiN.

6. The KTWPA device of any preceding claim, wherein the first substrate and the second substrate further include silicon having a surface oxide.

7. The KTWPA device of any preceding claim, wherein the plurality of spacers include gold stud bumps.

8. The KTWPA device of any preceding claim, wherein the vacuum gap has a pressure of less than or equal to 1 microTorr.

9. A quantum microwave measurement circuit, comprising:
a KTWPA device as defined in any preceding claim;
a first circulator coupled to a quantum circuit to receive a quantum measurement signal;
a first microwave triplexer coupled to the first circulator to receive the quantum measurement signal and further coupled to an input port of the KTWPA device, the first microwave triplexer receiving a bias-in voltage and a microwave pump-in signal;
a second microwave triplexer coupled to an output port of the KTWPA device to receive an amplified quantum measurement signal, the second microwave triplexer receiving a bias-out voltage and a microwave pump-out signal;
a second circulator coupled to the second microwave triplexer to receive the amplified quantum measurement signal; and
an analog-to-digital converter, ADC, coupled to the second circulator to receive the amplified quantum measurement signal and provide a quantum measurement value, optionally wherein the KTWPA device, the first circulator, the second circulator, the first microwave triplexer and the second microwave triplexer are cooled to less than 100 mK.

10. A method of fabricating a kinetic inductance travelling-wave parametric amplifier, KTWPA, device, the method comprising;
providing a first substrate;
fabricating a superconducting trace on the first substrate, the superconducting trace having a first height;
fabricating a plurality of spacers on the first substrate, the plurality of spacers having a second height greater than the first height of the superconducting trace;
providing a second substrate;
coupling a ground plane to the second substrate;
coupling the ground plane to the plurality of spacers; and
forming a superconducting transmission line assembly from the superconducting trace and the ground plane separated by a vacuum gap having the second height.

11. The method of fabricating a KTWPA device of claim 10, further comprising:
providing a metallic enclosure having a base with an inside top surface, sides, and an enclosure lid;
forming a vacuum cavity by the metallic enclosure for containing the first substrate and the second substrate to form the vacuum gap;
bonding the first substrate to the inside top surface of the base, the first substrate including a plurality of conductive pads; and
attaching a plurality of wire bonds between the plurality of conductive pads and the superconducting trace;
optionally wherein the method further comprises coupling a plurality of radio frequency, RF, connectors to the plurality of conductive pads, the plurality of RF connectors providing an input port and an output port.

12. The method of fabricating a KTWPA device of claim 10 or claim 11, further comprising arranging the superconducting trace in a serpentine pattern that is fabricated adjacent to the plurality of spacers on the first substrate.

13. The method of fabricating a KTWPA device of any of claims 10 to 12, wherein the superconducting trace is a superconducting thin film;
optionally wherein the superconducting thin film includes Niobium Titanium Nitride NbTiN.

14. The method of fabricating a KTWPA device of any of claims 10 to 13, wherein the first substrate and the second substrate include silicon having a surface oxide.

15. The method of fabricating a KTWPA device of any of claims 10 to 14, wherein the vacuum gap has a pressure of less than or equal to 1 microTorr.
